# EUROPEAN PATENT APPLICATION

(11) **EP 4 181 270 A1**
(43) Date of publication of application: **17.05.2023**
(21) Application number: 20953208.4
(22) Date of filing: 08.09.2020
(51) Int. Cl.: H01M 10/48, H01M 10/6567, H02J 7/00

(54) **EVALUATION HOLDER, EVALUATION UNIT, AND EVALUATING EQUIPMENT**

(71) Applicant: Hirata Corporation, Kumamoto-shi, Kumamoto 861-0198 (JP)
(72) Inventor: KANEKO, Toshihiko, Kumamoto-shi, Kumamoto 861-0198 (JP)
(74) Representative: Müller-Boré & Partner Patentanwälte PartG mbB
(86) International application number: PCT/JP2020/033996
(87) International publication number: WO 2022/054140

(57) **Abstract**

One aspect of the present invention relates to an evaluation holder, that holds a plurality of battery cells and can transfer the plurality of battery cells at once in characteristic evaluation of the plurality of battery cells, the evaluation holder characterized by comprising a bottom wall configured to align the plurality of battery cells aligned from one side to another side and place the plurality of battery cells, a peripheral wall provided around a periphery of the bottom wall to be higher than the plurality of battery cells, and a press mechanism that presses the plurality of battery cells from the one side to the other side, wherein the bottom wall and the peripheral wall form a reservoir configured to store a liquid.

## Description

### TECHNICAL FIELD

The present invention mainly relates to an evaluation unit.

### BACKGROUND ART

In general, an electronic device (or electronic component) can be mounted on a corresponding apparatus after it is confirmed by characteristic evaluation including various evaluation items that the electronic device satisfies predetermined criteria. An example of the electronic device is a battery cell. For example, a plurality of battery cells are unitized and used as the battery unit of an electric vehicle (EV). This can require a technique of implementing characteristic evaluation of a plurality of electronic devices at once/efficiently (for example, for various evaluation items in a relatively short time).

### CITATION LIST

### PATENT LITERATURE

PTL 1: Japanese Patent No. 6100196
PTL 2: Japanese Patent No. 5609694
PTL 3: Japanese Patent Laid-Open No. 2000-188135
PTL 4: Japanese Patent No. 5283527
PTL 5: Japanese Patent No. 5834359

### SUMMARY OF INVENTION

### TECHNICAL PROBLEM

In PTLs 1 to 5, an apparatus that executes a predetermined characteristic evaluation on a plurality of battery cells as evaluation targets is described. A technique capable of constituting such an apparatus relatively easily is required in addition to improvement of the safety of the evaluation.

The present invention has as its exemplary object to relatively easily constitute an apparatus capable of executing characteristic evaluation for a plurality of battery cells or other electronic devices, and improve the safety of the characteristic evaluation.

### SOLUTION TO PROBLEM

One aspect of the present invention relates to an evaluation holder, that holds a plurality of battery cells and can transfer the plurality of battery cells at once in characteristic evaluation of the plurality of battery cells, the evaluation holder characterized by comprising a bottom wall configured to align the plurality of battery cells aligned from one side to another side and place the plurality of battery cells, a peripheral wall provided around a periphery of the bottom wall to be higher than the plurality of battery cells, and a press mechanism that presses the plurality of battery cells from the one side to the other side, wherein the bottom wall and the peripheral wall form a reservoir configured to store a liquid.

### ADVANTAGEOUS EFFECTS OF INVENTION

According to the present invention, an apparatus capable of executing the characteristic evaluation can be relatively easily constituted, and the safety of the characteristic evaluation can be improved.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
Fig. 1 is a perspective view of an overall evaluation system according to an embodiment;
Fig. 2 is a perspective view of part of the evaluation system;
Fig. 3 is a perspective view of an evaluation holder and an auxiliary holder;
Fig. 4 is a perspective view of the evaluation holder and the auxiliary holder;
Fig. 5 is a perspective view of the evaluation holder and the auxiliary holder;
Fig. 6 is a perspective view of evaluation units of one column;
Fig. 7 is a perspective view of the evaluation units of one column;
Fig. 8 is a perspective view showing the internal structure of the evaluation unit;
Fig. 9 is a perspective view showing the internal structure of the evaluation unit;
Fig. 10 is a block diagram showing the system arrangement of the evaluation unit;
Fig. 11 is a front view schematically showing the structure of the evaluation unit;
Fig. 12A is a schematic view showing a structure for enabling connection between the evaluation units;
Fig. 12B is a schematic view showing a structure for enabling connection between the evaluation units;
Fig. 12C is a schematic view showing a structure for enabling connection between the evaluation units;
Fig. 13 is a schematic view showing an example when the evaluation units are arrayed; and
Fig. 14 is a schematic view showing an example of the arrangement of a gas delivery portion.

### DESCRIPTION OF EMBODIMENTS

Hereinafter, embodiments will be described in detail with reference to the attached drawings. Note, the following embodiments are not intended to limit the scope of the claimed invention, and limitation is not made to an invention that requires a combination of all features described in the embodiments. Two or more of the multiple features described in the embodiments may be combined as appropriate. Furthermore, the same reference numerals are given to the same or similar configurations, and redundant description thereof is omitted.

### (Outline of Evaluation System)

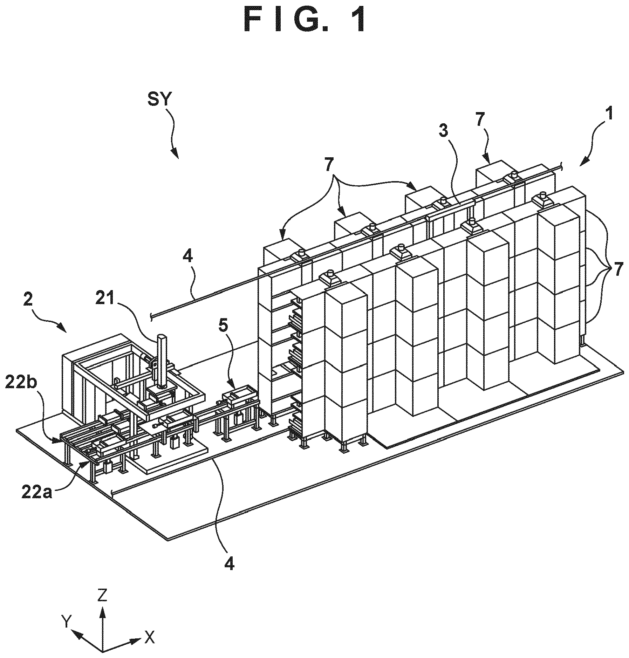

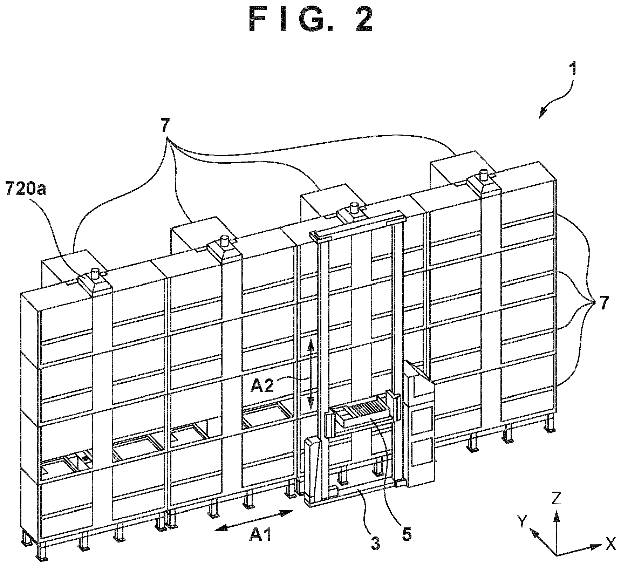

Fig. 1 shows an example of the arrangement of an evaluation system SY according to an embodiment. Fig. 2 shows part of the evaluation system SY To facilitate understanding, the X, Y, and Z directions perpendicular to each other are indicated in the drawings. The X direction corresponds to the right-and-left direction, the Y direction corresponds to the direction of depth, and the Z direction corresponds to the up-and-down direction.

The evaluation system SY includes an evaluation apparatus 1, a preparation unit 2, and a conveyance unit 3. The evaluation apparatus 1 is constituted by arraying evaluation units 7. In the embodiment, the evaluation apparatus 1 is so constituted that arrays of the evaluation units 7 (four rows × four columns) in the X and Z directions are paired to face each other in the Y direction. Details of the structure of each evaluation unit 7 will be described later.

The Z direction may be expressed as a column direction or stacking direction (direction in which the evaluation units 7 are stacked), and the X direction may be expressed as a row direction. The four evaluation units 7 aligned in the Z direction correspond to the first, second, third, and fourth stages in order from the bottom.

The preparation unit 2 makes preparations for a predetermined characteristic evaluation. In the embodiment, a plurality of battery cells 5 are sequentially evaluated by exchanging a series of electrical signals. The preparation unit 2 makes preparations for characteristic evaluation by holding the battery cells 5 in an evaluation holder 6 so that they can be transferred at once. The preparation unit 2 makes preparations for the next step by taking out the battery cells 5 from the evaluation holder 6. In the following description, the evaluation holder 6 is sometimes simply referred to as the holder 6.

Examples of the contents of characteristic evaluation are various electrical characteristic evaluations (to be simply referred to as "characteristic evaluation" hereinafter) including evaluation of the charge/discharge time, evaluation of a temporal change of the output voltage, and evaluation of the service life of a battery. In the following description, the battery cells 5 are sometimes referred to as the evaluation targets 5.

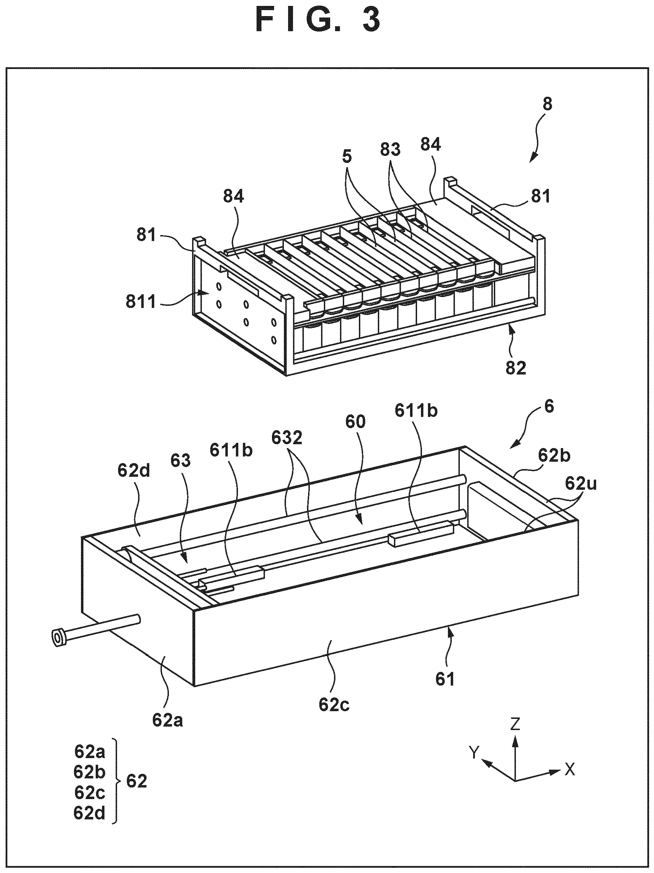

The battery cells 5 are held by the evaluation holder 6 via an auxiliary holder 8 that fixes their relative positions (see Figs. 3 to 5). The battery cells 5 can be transferred at once by the auxiliary holder 8 before/after characteristic evaluation, details of which will be described later. The battery cells 5 are held by the evaluation holder 6 together with the auxiliary holder 8 during characteristic evaluation, so they can be transferred at once while the safety of the characteristic evaluation can be improved.

Details of the structures of the evaluation holder 6 and auxiliary holder 8 will be described later. The preparation unit 2 includes a manipulator 21, a first transfer mechanism 22a, and a second transfer mechanism 22b. The manipulator 21 sets the auxiliary holder 8 (auxiliary holder 8 fixing the battery cells 5) in the holder 6, and takes out the auxiliary holder 8 from the holder 6. The transfer mechanism 22a transfers, to the conveyance unit 3, the holder 6 (holder 6 holding the plurality of battery cells 5 together with the auxiliary holder 8) received from the manipulator 21 and transfers, to the manipulator 21, the holder 6 received from the conveyance unit 3. The transfer mechanism 22b transfers, to the manipulator 21, the auxiliary holder 8 received from an apparatus (not shown) in a step preceding characteristic evaluation and transfers, to an apparatus in the next step, the auxiliary holder 8 received from the manipulator 21.

Rails 4 are laid between the evaluation apparatus 1 and the preparation unit 2. As indicated by an arrow A1 in Fig. 2, the conveyance unit 3 can slide along the rails 4 and reciprocate between the evaluation apparatus 1 and the preparation unit 2. The conveyance unit 3 conveys the evaluation targets 5 between the evaluation apparatus 1 and the preparation unit 2.

As indicated by an arrow A2 in Fig. 2, the conveyance unit 3 can also elevate (move in the Z direction) the holder 6. The conveyance unit 3 can convey the evaluation targets 5 to an arbitrary one of the four evaluation units 7 aligned in the Z direction and set them. Note that from this viewpoint, the Z direction can be expressed as the elevating direction of the holder 6 by the conveyance unit 3. The evaluation targets 5 evaluated by the evaluation unit 7 are then taken out from the evaluation unit 7 by the conveyance unit 3 and conveyed to the preparation unit 2.

### (Evaluation Target of Characteristic Evaluation)

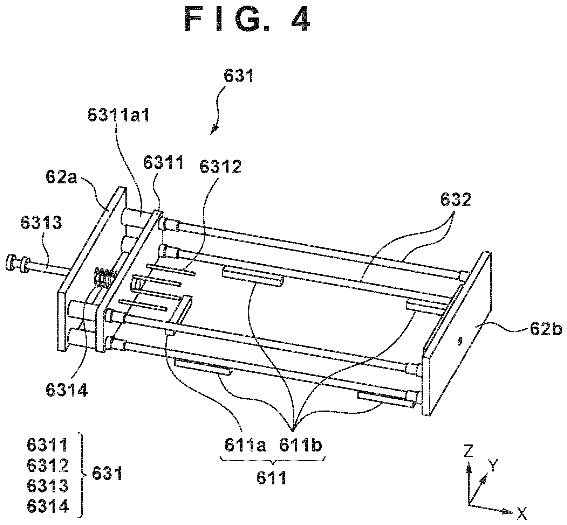

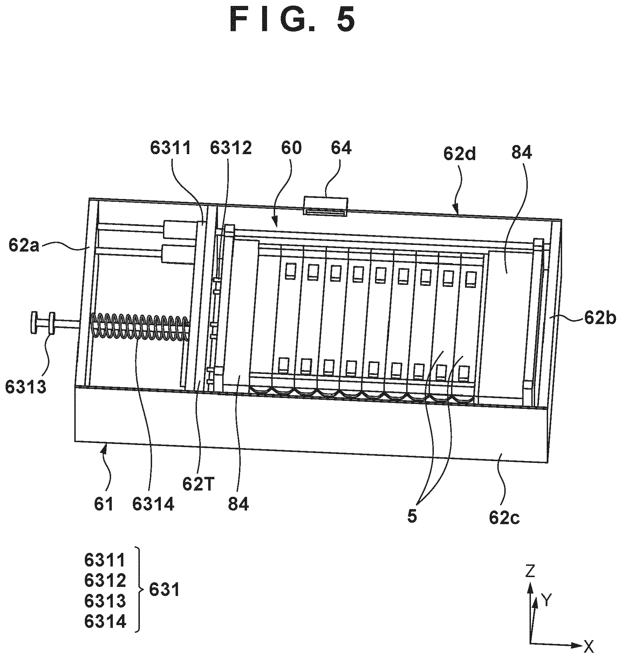

Figs. 3 to 5 show an example of the arrangements of the evaluation holder 6 and auxiliary holder 8. Fig. 3 is a perspective view showing a state before the auxiliary holder 8 fixing the battery cells (evaluation targets) 5 is set in the evaluation holder 6. Fig. 4 is a perspective view showing the internal structure of the evaluation holder 6, part of which is not shown. Fig. 5 is a perspective view showing a state after the auxiliary holder 8 is set in the evaluation holder 6. In Figs. 3 to 5, the X, Y, and Z directions are represented in accordance with directions at the time of setting in the evaluation unit 7.

The auxiliary holder 8 includes a pair of side wall plates 81, a bottom wall plate 82, a plurality of partition members 83, and a pair of support members 84. The paired side wall plates 81 are arranged to face each other in the X direction. The bottom wall plate 82 is provided to connect the paired side wall plates 81. The partition members 83 are arrayed on the bottom wall plate 82 so that each of them can move in the X direction between the paired side wall plates 81. The single battery cell 5 is set between two adjacent partition members 83 so that the battery cell 5 can be inserted and removed. The paired support members 84 are arranged on the bottom wall plate 82 in correspondence with the paired side wall plates 81. Each support member 84 is arranged to fill the gap between the corresponding side wall plate 81 and the plurality of partition members 83. For each support member 84, for example, a material having a desired strength and a desired formability such as a resin material can be used.

With this arrangement, the auxiliary holder 8 supports and fixes the plurality of battery cells 5. Press holes 811 are formed in one (on the side of a press mechanism 63 to be described below) of the paired side wall plates 81, details of which will be described later. The press holes 811 may also be formed in the other side wall plate 81.

The evaluation holder 6 includes a bottom wall 61, a peripheral wall 62, and the press mechanism 63. The bottom wall 61 is configured to align the plurality of battery cells 5 from one side to the other side (X direction here) and place them. In the embodiment, the plurality of battery cells 5 are placed on the bottom wall 61 via the auxiliary holder 8. The bottom wall 61 has a positioning portion 611 for positioning the auxiliary holder 8. The positioning portion 611 is provided to regulate a positional error of the auxiliary holder 8 with respect to the bottom wall plate 82. In the embodiment, the positioning portion 611 includes a first regulation portion 611a that regulates a positional error to one side in the X direction, and second regulation portions 611b that regulate a positional error in the Y direction.

The peripheral wall 62 is provided around the periphery of the bottom wall 61. The peripheral wall 62 includes a first wall 62a and a second wall 62b as two portions arranged to face each other in the X direction, and a third wall 62c and a fourth wall 62d as two portions arranged to face each other in the Y direction. The peripheral wall 62 is provided to be higher than the plurality of placed battery cells 5, details of which will be described later. More specifically, the peripheral wall 62 includes a peripheral wall upper end 62u serving as an upper end higher than the upper end of the battery cell 5. Note that the positioning portion 611 may be provided on the peripheral wall 62 instead of/accessory to the bottom wall 61, or the peripheral wall 62 may also serve as the positioning portion 611.

The press mechanism 63 is configured to press the plurality of battery cells 5 in one direction (X direction here). In the embodiment, the press mechanism 63 includes a moving body 631 and guide members 632. The moving body 631 is provided on one (wall 62a side here) of the walls 62a and 62b, and configured to push, move, and press the plurality of battery cells 5 in the X direction.

The moving body 631 includes a plate 6311, press members 6312, a press operation portion 6313, and an elastic member 6314. The plate 6311 is arranged in parallel with the walls 62a and 62b. The guide members 632 are bar members inserted through the plate 6311, and slidably guide the moving body 631 in the X direction. The plate 6311 includes sliding members 6311a that are engaged with the guide members 632 and slide. Each press member 6312 extends from the plate 6311 in the X direction and is configured to be inserted into the corresponding press hole 811 formed in the side wall plate 81. In the embodiment, a bar member having a predetermined length and diameter is used as the press member 6312. The plate 6311, the press members 6312, and the press operation portion 6313 are integrated, and the plate 6311 and the press members 6312 can be moved in the X direction by manipulating the press operation portion 6313 by the manipulator 21 (or the operator). The elastic member 6314 is interposed between the wall 62a and the plate 6311 so as to apply a biasing force for moving the moving body 631 in one direction (X direction here). In the embodiment, the elastic member 6314 generates a biasing force to the plate 6311 so that the side wall plate 81 and the plate 6311 come close to each other. The press operation portion 6313 is inserted from one side of the wall 62a to the other side and movably supported by the wall 62a.

With this arrangement, the evaluation holder 6 holds the plurality of battery cells 5 fixed or supported by the auxiliary holder 8. For example, in the preparation unit 2, the manipulator 21 moves the plate 6311 and the press members 6312 in the X direction so that the press operation portion 6313 is operated to insert the press members 6312 into the press holes 811. A locking portion (not shown) is provided on the press operation portion 6313, and the manipulator 21 is locked to the press operation portion 6313 using the locking portion to enable the operation of the press operation portion 6313. The plate 6311 moves by the repulsion force of the elastic member 6314 using the wall 62a as a reference. Even if the engagement between the manipulator 21 and the locking portion of the press operation portion 6313 is canceled, the press force is kept applied to the moving body 631, and the plurality of battery cells 5 can be held in the evaluation holder 6 while kept pressed. This can prevent generation of a positional error of each battery cell 5 during characteristic evaluation.

As another embodiment, the press operation portion 6313 may be provided so that it can be threadably mounted on the wall 62a. That is, the press operation portion 6313 may be constituted to rotate in one direction and move the plate 6311 and the press members 6312 in the +X direction, and rotate in the opposite direction and move the plate 6311 and the press members 6312 in the -X direction.

The auxiliary holder 8 may be expressed as a cartridge, a magazine, or the like. The evaluation holder 6 may be expressed as a tray, a case, a housing, or the like.

As shown in Fig. 5, in the embodiment, the bottom wall 61 and the peripheral wall 62 form a reservoir 60 capable of storing a predetermined liquid. The peripheral wall 62 is provided to be higher than the evaluation target 5. When only a predetermined amount of liquid is stored in the reservoir 60 or the reservoir 60 is fully filled with it, all the evaluation targets 5 can be immersed in the liquid. The liquid is, for example, a non-flammable liquid (to be simply referred to as a "liquid" hereinafter) such as water, seawater, or a fire-extinguishing foam, details of which will be described later.

A drainage portion 64 capable of draining a liquid is formed in the peripheral wall 62. In the embodiment, the drainage portion 64 is formed in the wall 62d. When a liquid is stored up to a predetermined height, it is drained from the drainage portion 64. The drainage portion 64 suffices to be provided at a position higher than the evaluation target 5. All the evaluation targets 5 can be immersed in the liquid even during drainage of the liquid from the drainage portion 64. The drainage portion 64 in the embodiment is provided at a position higher than the evaluation target 5 and a position lower than the upper edge of the peripheral wall 62, and guides the liquid to a predetermined drainage destination before the liquid overflows from the upper edge of the peripheral wall 62.

A reservoir wall 62T shown in Fig. 5 is a plate member having a predetermined thickness, and openings of a diameter slightly larger than the outer diameter of the press member 6312 are formed in the reservoir wall 62T so that the press members 6312 can be inserted and moved. The press members 6312 are formed to close the openings of the reservoir wall 62T. The reservoir wall 62T is provided so that it can store a liquid together with the press members 6312 of the moving body 631. More specifically, the reservoir 60 is formed from the bottom wall 61, the walls 62b, 62c, and 62d, and a region demarcated by the reservoir wall 62T. When a liquid is stored in the reservoir 60, the plurality of battery cells 5 can be cooled at once. Since the reservoir wall 62T is interposed between the walls 62a and 62b and provided on the bottom wall 61 from the wall 62c to the wall 62d, the amount of liquid stored in the reservoir 60 can be decreased and the reservoir efficiency can be increased. As another embodiment, the reservoir wall 62T may be omitted.

### (Arrangement of Evaluation Unit)

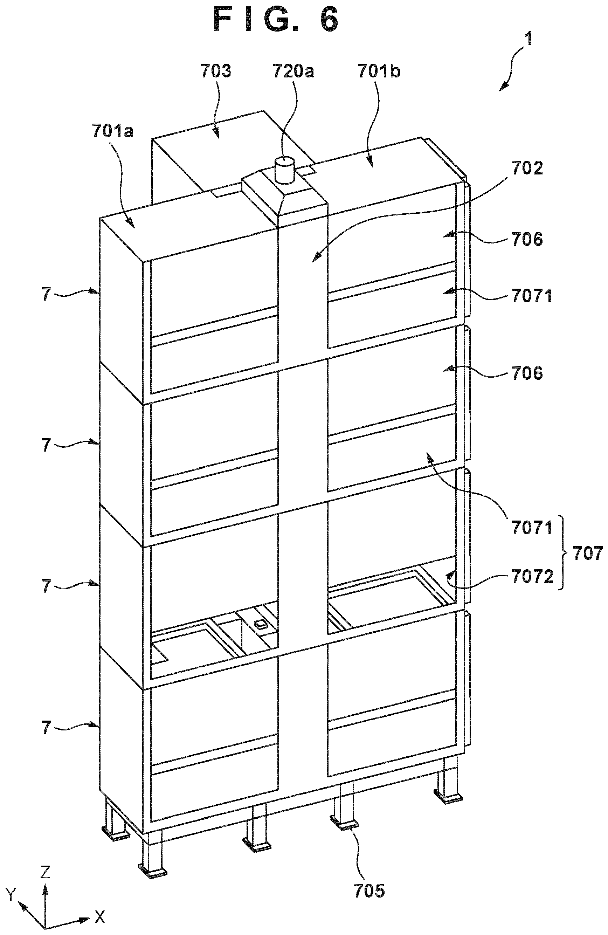

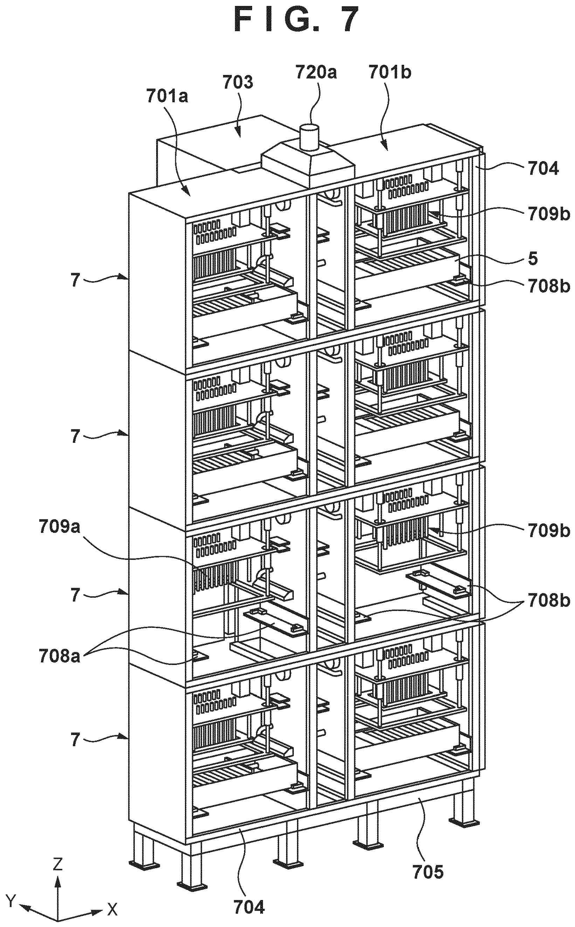

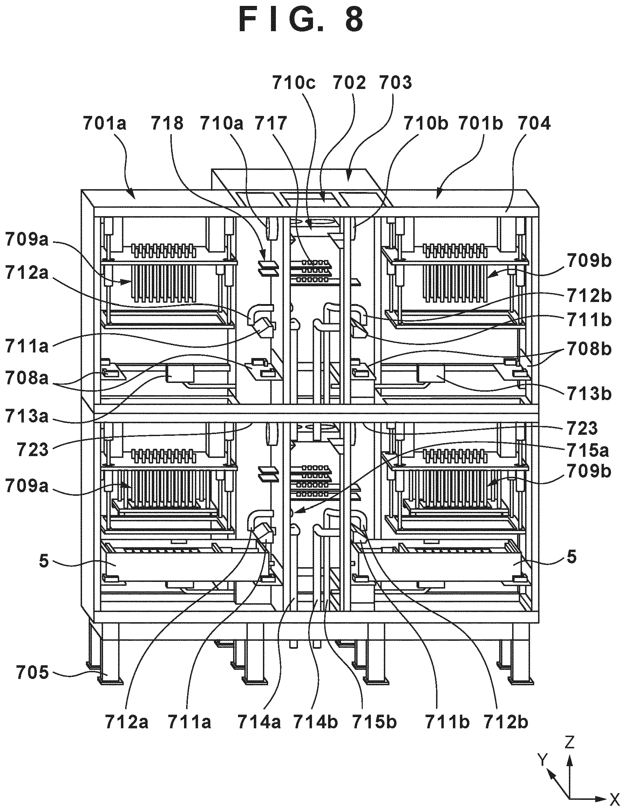

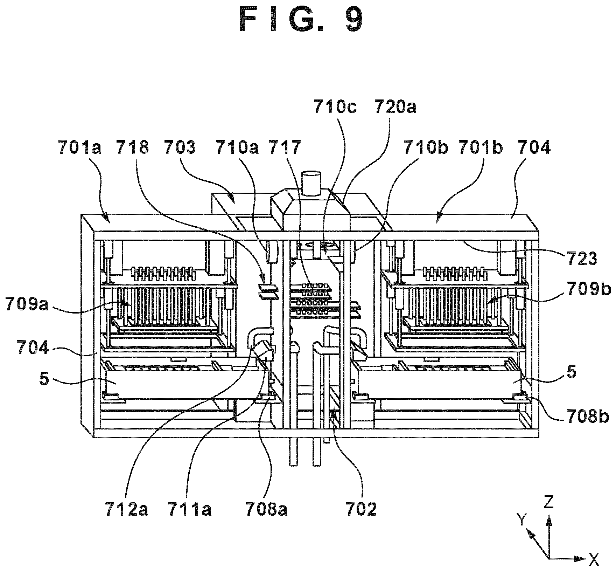

An example of the structure of the evaluation apparatus 1 will be described with reference to Figs. 6 to 9. Fig. 6 is a perspective view showing part (for one column) of the evaluation apparatus 1. Fig. 7 is a perspective view showing the internal structure of this part of the evaluation apparatus 1. Fig. 8 is an enlarged perspective view of the internal structure of the evaluation units 7 at the first and second stages. Fig. 9 is an enlarged perspective view of the internal structure of the evaluation unit 7 at the fourth stage. The evaluation apparatus 1 includes the evaluation units 7 stacked in the Z direction. Each evaluation unit 7 includes a first evaluation chamber 701a, a second evaluation chamber 701b, a supply chamber/exhaust chamber 702, a control chamber 703, and a support frame 704.

The evaluation apparatus 1 also includes a gas outlet 720a for letting a gas out of the stacked evaluation units 7 from the inside of the evaluation units 7. The gas outlet 720a is provided at the top one of the plurality of evaluation units 7 stacked in the Z direction, and demarcates, at a predetermined position of the evaluation apparatus 1, the discharge position of the gas flowing up after discharged from each evaluation unit 7 via the supply chamber/exhaust chamber 702. The gas outlet 720a includes a hood 720a1 having an opening for releasing a gas outside the evaluation apparatus 1. The gas outlet 720a also includes an air exhaust mechanism 720 for forcibly directing the flow of a gas in a predetermined direction.

Each of the evaluation chambers 701a and 701b is configured to accommodate the evaluation holder 6 in characteristic evaluation. The supply chamber/exhaust chamber 702 is provided adjacent to the evaluation chamber 701a in the X direction. The evaluation chamber 701b is adjacent to the supply chamber/exhaust chamber 702 in the X direction and provided on a side of the supply chamber/exhaust chamber 702 opposite to the evaluation chamber 701a. The control chamber 703 is adjacent to the supply chamber/exhaust chamber 702 in the Y direction. Note that each of the evaluation chambers 701a and 701b is partially adjacent to the control chamber 703 in the Y direction. That is, the paired evaluation chambers 701a and 701b are positioned on two sides of the supply chamber/exhaust chamber 702 (the evaluation chamber 701a is positioned on the first side of the supply chamber/exhaust chamber 702, and the evaluation chamber 701b is positioned on the second side of the supply chamber/exhaust chamber 702). The control chamber 703 is positioned on the far side of the supply chamber/exhaust chamber 702 (the control chamber 703 is positioned on the third side of the supply chamber/exhaust chamber 702).

The support frame 704 frames the evaluation chambers 701a and 701b, the supply chamber/exhaust chamber 702, and the control chamber 703 so as to demarcate them, and integrally supports constituent devices included in them. The support frame 704 is configured to be connected to the support frame 704 of another evaluation unit 7, and two or more evaluation units 7 can be connected to each other, details of which will be described later. A support stand 705 that supports the plurality of evaluation units 7 is arranged below the evaluation apparatus 1, and the support frame 704 of the evaluation unit 7 at the first stage (lowest stage) is connected to the support stand 705 and fixed.

The evaluation unit 7 includes partitions 706. The evaluation unit 7 also includes opening/closing portions 707 for the respective evaluation chambers 701a and 701b. The partitions 706 are supported by the support frame 704. The partitions 706 are provided between the inside and outside of the evaluation chambers 701a and 701b, the supply chamber/exhaust chamber 702, and the control chamber 703 that are demarcated by the support frame 704. The partitions 706 are also provided at the front surface portion, rear surface portion, two side surface portions, top surface portion, and bottom surface portion of the main body of the evaluation unit 7, forming respective internal spaces. More specifically, the partitions 706 are arranged at the front surface portion, rear surface portion, two side surface portions, top surface portion, and bottom surface portion of each of the evaluation chambers 701a and 701b. Also, the partitions 706 are arranged at the front surface portion, rear surface portion, and two side surface portions of the supply chamber/exhaust chamber 702. Further, the partitions 706 are arranged at the front surface portion, rear surface portion, two side surface portions, top surface portion, and bottom surface portion of the control chamber 703.

The opening/closing portions 707 are provided at the front surface portions of the evaluation chambers 701a and 701b, respectively. The opening/closing portions 707 include door members 7071 and opening/closing mechanisms 7072. The door members 7071 are respectively provided to be openable/closable at portions where the evaluation holder 6 is loaded/unloaded at the front surface portions of the evaluation chambers 701a and 701b. The door members 7071 partition the front surface portions of the respective evaluation chambers 701a and 701b together with the partitions 706 arranged at the front surface portions. In the embodiment, the door member 7071 is a slide door that is opened/closed by vertical movement. As another embodiment, the door member 7071 may be of another type such as a rotary door. The opening/closing mechanism 7072 includes, for example, an electric motor, a rail, and a slider, and implements the opening/closing operation of the door member 7071. The door member 7071 may be coupled to an operation portion such as an evaluation execution portion 709a (to be described later) so as to interlock the opening/closing operation of the door member 7071 with the operation of the operation portion.

The evaluation unit 7 further includes, in the evaluation chamber 701a, first holder support portions 708a, the first evaluation execution portion 709a, a first communication portion 710a, a first gas supply portion 711a, a first liquid supply portion 712a, and a first liquid receiving portion 713a.

The holder support portions 708a are configured to support the evaluation holder 6 at predetermined positions. In the embodiment, the paired holder support portions 708a are provided on the left and right sides of the support frame 704 on the side walls in the evaluation chamber 701a, and are configured to place the holder 6 on them.

The evaluation execution portion 709a is configured to execute characteristic evaluation on the evaluation targets 5 held by the holder 6. The evaluation execution portion 709a is provided on the support frame 704 so that it can be elevated in the evaluation chamber 701a, and includes, for example, an electric motor, a rail, a slider, a test probe, and a driver for it. For example, when characteristic evaluation is performed, the evaluation execution portion 709a moves down, a plurality of probes included in the evaluation execution portion 709a electrically contact the electrode portions of the respective evaluation targets 5, and measurement processing is performed in accordance with a predetermined evaluation program. When no characteristic evaluation is performed, the evaluation execution portion 709a moves up, and the plurality of probes included in the evaluation execution portion 709a move apart from the evaluation targets 5.

The evaluation execution portion 709a includes an opening/closing coupling portion (not shown) coupled to the door member 7071. Since the opening/closing coupling portion and part of the door member 7071 are coupled, the closing operation of the door member 7071 is interlocked with the down operation of the evaluation execution portion 709a, the inside and outside of the evaluation chamber 701a are partitioned, and then evaluation is executed. Upon completion of the evaluation, the opening operation of the door member 707 is interlocked with the up operation of the evaluation execution portion 709a, the inside and outside of the evaluation chamber 701a communicate with each other, and the evaluation holder 6 can be conveyed.

The communication portion 710a, the gas supply portion 711a, and the liquid supply portion 712a are juxtaposed on a side (supply chamber/exhaust chamber 702 side here) in the evaluation chamber 701a. More specifically, the communication portion 710a, the gas supply portion 711a, and the liquid supply portion 712a are provided to pass through the partition 706 supported by the support frame 704 on a side (supply chamber/exhaust chamber 702 side here) in the evaluation chamber 701a.

The communication portion 710a is provided to make the evaluation chamber 701a and the supply chamber/exhaust chamber 702 communicate with each other. More specifically, the communication portion 710a is arranged at an upper portion of the evaluation chamber 701a above the upper end of the peripheral wall 62 of the evaluation holder 6 placed on the first holder support portions 708a of the evaluation chamber 701a. The communication portion 710a includes an air guide mechanism such as a fan constituted to guide a gas (for example, air) from the evaluation chamber 701a to the supply chamber/exhaust chamber 702. The supply chamber/exhaust chamber 702 is open in the Z direction (respectively at upper and lower portions), details of which will be described later. The communication portion 710a prevents the temperature rise of the evaluation chamber 701a by discharging, to the supply chamber/exhaust chamber 702, a high-temperature gas staying at an upper portion of the evaluation chamber 701a. When a gas heavier than air supplied from the gas supply portion 711a is supplied, the communication portion 710a can efficiently replace the gas in the evaluation chamber 701a in cooperation with the gas supply portion 711a by discharging the air from the upper portion of the evaluation chamber 701a to the supply chamber/exhaust chamber 702.

The gas supply portion 711a is configured to supply a predetermined gas to the evaluation chamber 701a. More specifically, the gas supply portion 711a is arranged at a position above the upper end of the peripheral wall 62 of the evaluation holder 6 placed on the first holder support portions 708a of the evaluation chamber 701a, where a gas is supplied from the gas supply portion 711a so as to stay in the reservoir 60 of the evaluation holder 6. For example, the gas supply portion 711a can supply cool air toward the evaluation targets 5 during characteristic evaluation and supply a non-flammable gas such as a digestive gas in a predetermined case, details of which will be described later. Respective gases of relatively high specific gravities stay in the reservoir 60 of the evaluation holder 6 placed on the first holder support portions 708a of the evaluation chamber 701a. Thus, the evaluation targets 5 placed in the evaluation holder 6 can obtain the effect of the efficiently supplied gas.

The liquid supply portion 712a is configured to supply a liquid into the holder 6. More specifically, the liquid supply portion 712a is arranged at a position above the upper end of the peripheral wall 62 of the evaluation holder 6 placed on the first holder support portions 708a of the evaluation chamber 701a, where a liquid is supplied from the liquid supply portion 712a so as to stay in the reservoir 60 of the evaluation holder 6. The liquid supply portion 712a can supply a liquid into the holder 6 in a predetermined case, details of which will be described later. The liquid stays in the reservoir 60. The surroundings of the evaluation targets 5 placed in the reservoir 60 of the evaluation holder 6 are filled with the liquid and cooled by it. The liquid receiving portion 713a is arranged at a position below the drainage portion 64 and receives a liquid flowing from the holder 6.

The evaluation unit 7 further includes, in the evaluation chamber 701b, second holder support portions 708b, a second evaluation execution portion 709b, a second communication portion 710b, a second gas supply portion 711b, a second liquid supply portion 712b, and a second liquid receiving portion 713b.

The elements 708b to 713b have functions similar to those of the above-described elements 708a to 713a of the evaluation chamber 701a. The elements 708b to 713b are provided on the support frame 704 similarly to the elements 708a to 713a. In the embodiment, the elements 708a to 713a and the elements 708b to 713b are arranged horizontally symmetrically about the supply chamber/exhaust chamber 702.

The evaluation unit 7 further includes, in the supply chamber/exhaust chamber 702, gas flow paths 714a and 714b and liquid flow paths 715a and 715b. The gas flow path 714a is connected to the gas supply portion 711a arranged in the evaluation chamber 701a, and the gas flow path 714b is connected to the gas supply portion 711b arranged in the evaluation chamber 701b. The liquid flow path 715a is connected to the liquid supply portion 712a arranged in the evaluation chamber 701a, and the liquid flow path 715b is connected to the liquid supply portion 712b arranged in the evaluation chamber 701b. Pipes or tubes are used for the flow paths 714a, 714b, 715a, and 715b, and the supply portions 711a, 711b, 712a, and 712b form the distal ends of the pipes or tubes. Note that the supply portion 711a and the like may be provided as members integrated with the corresponding flow path 714a and the like connected to them, or as members separate from the flow path 714a and the like.

The supply chamber/exhaust chamber 702 accommodates the above-mentioned flow paths 714a, 714b, 715a, and 715b respectively connected to the supply portions 711a, 711b, 712a, and 712b, and may be simply referred to as a supply chamber. Alternatively, the supply chamber/exhaust chamber 702 may be referred to as a gas supply chamber because it accommodates the gas flow paths 714a and 714b, or a liquid supply chamber because it accommodates the liquid flow paths 715a and 715b. The supply chamber/exhaust chamber 702 can discharge, outside the evaluation unit 7, a gas (for example, air) let out from the evaluation chambers 701a and 701b respectively via the communication portions 710a and 710b, and may be simply referred to as an exhaust chamber or an exhaust path.

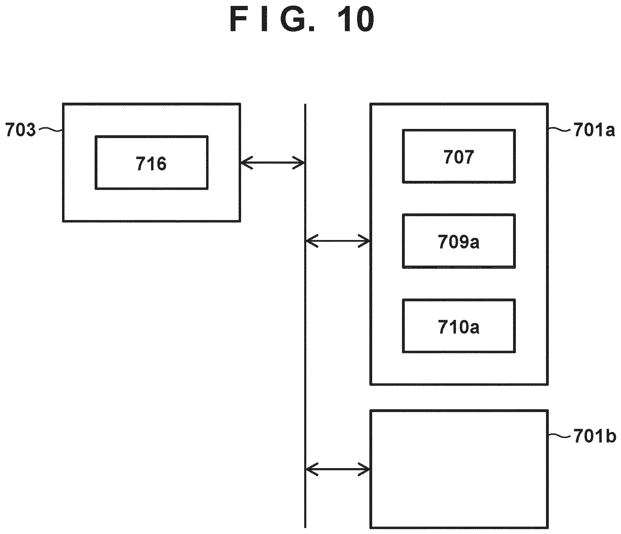

Fig. 10 is a block diagram showing the system arrangement of the evaluation unit 7. The evaluation unit 7 further includes a controller 716. The controller 716 is arranged in the control chamber 703 and functions as a system controller in the evaluation unit 7. The controller 716 can drive, for example, a motor (not shown) to open/close the opening/closing portion 707 (door member 7071 by the opening/closing mechanism 7072). The controller 716 can also output, for example, a predetermined control signal to move up/down the evaluation execution portion 709a and/or 709b and perform characteristic evaluation, or drive the air guide mechanism (for example, fan) of the communication portion 710a and/or 710b. Accessorily, the controller 716 may supply a gas by the gas supply portion 711a and/or 711b or supply a liquid by the liquid supply portion 712a and/or 712b.

Referring again to Figs. 6 to 9, the evaluation unit 7 includes, in the control chamber 703, the controller 716 and a third communication portion 710c. The controller 716 controls a control device included in the evaluation unit 7 and an evaluation device that evaluates the evaluation target 5. The controller 716 is supported by the support frame 704 demarcating the control chamber 703. The third communication portion 710c connects the supply chamber/exhaust chamber 702 and the controller 716, and makes their internal spaces communicate with each other. In the controller 716, an air blower (not shown) is constituted to let out gases in the control chamber 703 and the controller 716 to the supply chamber/exhaust chamber 702.

The evaluation unit 7 further includes wiring members 717 and wiring insertion portions 718. The wiring members 717 electrically connect the evaluation execution portion 709 and the controller 716, and accessorily electrically connect other elements (opening/closing mechanism 7072 and the like) and the controller 716. The wiring members 717 can include a power supply for supplying power necessary to evaluate the evaluation target 5. The wiring member 717 can be a cable, a wiring harness, or the like. The wiring insertion portions 718 are configured to insert the wiring members 717 from the control chamber 703 to the evaluation chamber 701a, the evaluation chamber 701b, and the supply chamber/exhaust chamber 702, respectively.

In the evaluation chamber 701a, the first holder support portions 708a are provided on first holder support frame portions of the support frame 704, and the first evaluation execution portion 709a is provided on a first evaluation support frame portion. In the evaluation chamber 701a, the first liquid receiving portion 713a is provided on a first liquid receiving frame portion of the support frame 704. In the evaluation chamber 701a, the first communication portion 710a, the first gas supply portion 711a, and the first liquid supply portion 712a are provided to pass through the partition 706 interposed between the evaluation chamber 701a and the supply chamber/exhaust chamber 702. The partition 706 is provided on a first supply/discharge support frame portion of the support frame 704.

In the evaluation chamber 701b, the second holder support portions 708b are provided on second holder support frame portions of the support frame 704, and the second evaluation execution portion 709b is provided on a second evaluation support frame portion. In the evaluation chamber 701b, the second liquid receiving portion 713b is provided on a second liquid receiving frame portion of the support frame 704. In the evaluation chamber 701b, the second communication portion 710b, the second gas supply portion 711b, and the second liquid supply portion 712b are provided to pass through the partition 706 interposed between the evaluation chamber 701b and the supply chamber/exhaust chamber 702. The partition 706 is provided on a second supply/discharge support frame portion of the support frame 704.

In the control chamber 703, the controller 716 is provided on a control support frame portion of the support frame 704. In the control chamber 703, the third communication portion 710c is provided to pass through an opening formed in the partition 706 interposed between the control chamber 703b and the supply chamber/exhaust chamber 702. The partition 706 is provided on the support frame 704 on the third side of the supply chamber/exhaust chamber 702.

The evaluation apparatus 1 can be assembled by arraying the plurality of above-described evaluation units 7. Although arrays of evaluation units 7 in four rows × four columns are paired and arranged in the embodiment, the number of rows and/or columns is not limited to this example.

In the embodiment, each evaluation unit 7 includes a pair of evaluation chambers 701a and 701b. As for the evaluation chambers 701a or 701b of each set, the evaluation chambers 701a or 701b are arrayed in four rows × eight columns. For example, given evaluation chambers 701a are arranged in the first column, and corresponding evaluation chambers 701b are arranged in the second column. In this case, the supply chamber/exhaust chamber 702 is arranged on the second column side with respect to the evaluation chamber 701a and on the first column side with respect to the evaluation chamber 701b. By similar procedures, other evaluation chambers 701a are arranged in the Kth column, corresponding evaluation chambers 701b are arranged in the (K+1)th column, and another supply chamber/exhaust chamber 702 is arranged between them (here, K = 3, 5, or 7. For a larger number of columns, K is an odd number ≥ 3). At this time, the evaluation chambers 701b on the (K-1)th column and the evaluation chambers 701a on the Kth column are adjacent to each other without the intervention of the supply chamber/exhaust chamber 702.

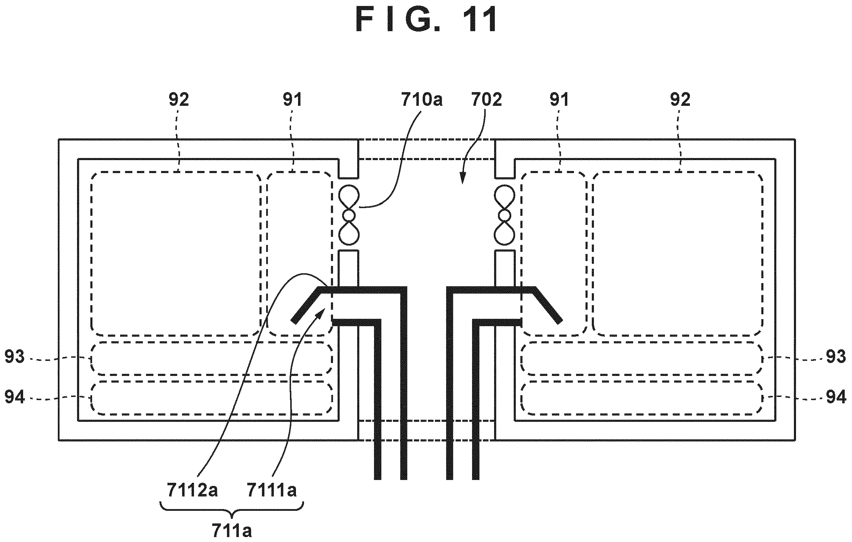

Fig. 11 is a front view schematically showing the structure of the evaluation unit 7 (viewed from the opening/closing portion 707 side). This also applies to the evaluation chamber 701b. The evaluation chamber 701a is divided into regions 91 to 94. Note that the regions 91 to 94 are represented as areas in the front view, but suffice to be established at any portion in the three-dimensional space.

The first region 91 and the second region 92 are adjacent to each other in the X direction. The gas supply portion 711a and the communication portion 710a (and the liquid supply portion 712a (not shown here)) are arranged in the region 91, and the region 91 is set as a supply/discharge area. The evaluation execution portion 709a is arranged in the region 92, and the region 92 is set as an evaluation device area.

The third region 93 is adjacent to the regions 91 and 92 in the Z direction (below here). The holder 6 that holds the evaluation targets 5 is arranged in the region 93, and the region 93 is set as an evaluation target arrangement area.

The fourth region 94 is positioned on a side of the region 93 opposite to the regions 91 and 92 (that is, below the region 93). The liquid receiving portion 713a that receives a liquid from the holder 6 is arranged in the region 94, and the region 94 is set as an auxiliary area.

Since the region 91 is provided above the region 93, supply of a gas and liquid to the evaluation target 5 can be executed. Since the region 92 is provided above the region 93, characteristic evaluation can be executed on the evaluation target 5. Since the regions 91 and 92 are adjacent to each other, the two operations can be independently executed. Since the region 94 is provided below the region 93, that is, a space exists below the holder support portion 708, the conveyance unit 3 can cope with various forms of loading/unloading such as loading/unloading to/from the evaluation chamber 701a while supporting the evaluation holder 6 from below it. Since the regions 91 to 94 of the evaluation chamber 701a are set as dedicate functional regions, the arrangement of respective devices in the evaluation chamber 701a can be efficiently set.

Note that the holder 6 is accommodated in the evaluation chamber 701a to set the press mechanism 63 on a side opposite to the liquid supply portion 712a so that the liquid supply portion 712a can supply a liquid toward the reservoir 60 of the holder 6. The conveyance unit 3 may be configured to turn around the X direction of the holder 6 during conveyance.

As is apparent from Fig. 11, the gas supply portion 711a includes an opening portion 7111a and an extending portion 7112a, which also applies to the gas supply portion 711b. The opening portion 7111a can introduce a gas into the evaluation chamber 701a. The extending portion 7112a surrounds the opening portion 7111a, and extends toward an inside (from the region 91 toward the region 93 here) of the evaluation chamber 701a near the evaluation target 5 so as to efficiently guide a gas toward the evaluation target 5. Note that the shapes of the gas supply portions 711a and 711b similarly apply to those of the liquid supply portions 712a and 712b.

### (Evaluation Apparatus)

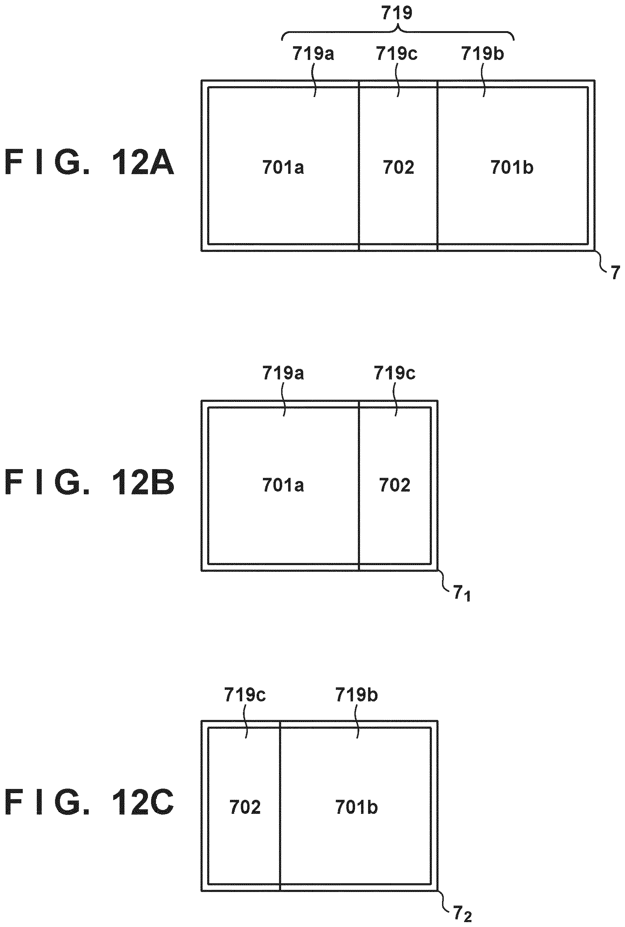

Figs. 12A to 12C are schematic views for explaining a structure for enabling connection (or coupling) between the evaluation units 7. The evaluation unit 7 further includes a connecting portion (coupling portion) 719 for connecting (or coupling) the evaluation unit 7 to another evaluation unit 7. The connecting portion 719 may be integrally provided on the support frame 704 or provided separately from the support frame 704.

The connecting portion 719 may be provided individually for each of the evaluation chambers 701a and 701b and the supply chamber/exhaust chamber 702, or integrally provided. The connecting portion 719 is preferably configured to connect each of the evaluation chamber 701 and the supply chamber/exhaust chamber 702 to any of the evaluation chamber 701 and the supply chamber/exhaust chamber 702 of another evaluation unit 7.

To facilitate understanding, in Fig. 12A, a portion of the connecting portion 719 corresponding to the evaluation chamber 701a will be referred to as a connecting portion 719a, a portion corresponding to the evaluation chamber 701b will be referred to as a connecting portion 719b, and a portion corresponding to the supply chamber/exhaust chamber 702 will be referred to as a connecting portion 719c. In other words, the above-described connecting portion 719 is configured to connect the connecting portions 719a, 719b, and 719c to each other.

According to this arrangement, the evaluation units 7 can be partially changed and connected, and the evaluation apparatus 1 can take various assembly forms. For example, the evaluation unit 7 includes a pair of evaluation chambers 701a and 701b in the embodiment, but a modification in which either of them is omitted can be combined as another embodiment. For example, in the embodiment, one support frame 704 is constituted for each evaluation unit 7. However, for example, the support frame 704 included in the evaluation unit 7 may be shared between two adjacent evaluation units 7. One sharable support frame can integrally support a plurality of evaluation chambers, supply chambers/exhaust chambers, and control chambers included in the plurality of evaluation units 7.

As shown in Fig. 12B, an evaluation unit (to be referred to as an evaluation unit 7i for distinction) according to the first modification includes the evaluation chamber 701a, the supply chamber/exhaust chamber 702, and the control chamber 703, and does not include the evaluation chamber 701b.

As shown in Fig. 12C, an evaluation unit (to be referred to as an evaluation unit 7₂ for distinction) according to the second modification includes the evaluation chamber 701b, the supply chamber/exhaust chamber 702, and the control chamber 703, and does not include the evaluation chamber 701a.

According to these forms, when assembling the evaluation apparatus 1, the evaluation unit 7i and/or 7₂ can be arrayed in addition to/instead of the evaluation unit 7. The evaluation apparatus 1 can be flexibly installed in accordance with an obstacle at an arrangement location.

As another embodiment, the evaluation units 7 (accessorily 7₁ and/or 7₂) can also be arrayed in different directions. For example, the evaluation units 7 whose front side is the +Y direction, and the evaluation units 7 whose front side is the -Y direction can also be arrayed alternately in the X direction and/or Z direction.

The connecting portion 719c corresponding to the supply chamber/exhaust chamber 702 is constituted to open the supply chamber/exhaust chamber 702 outside in the Z direction. That is, the connecting portion 719c can discharge, outside the evaluation unit 7, air guided to the supply chamber/exhaust chamber 702 via the evaluation chamber 701a and/or 701b and the communication portion 710a and/or 710b.

The connecting portion 719c corresponding to an upper end of the supply chamber/exhaust chamber 702 in the column direction allows attaching the air exhaust mechanism 720 (see Fig. 9) serving as an accessory unit of the gas outlet 720a. The supply chamber/exhaust chamber 702 is open in the Z direction, so when the evaluation units 7 are arrayed in the Z direction, the supply chambers/exhaust chambers 702 of the evaluation units 7 adjacent to each other in the Z direction (stacking direction of the evaluation units 7) communicate with each other. At the upper end of the supply chamber/exhaust chamber 702 of the top evaluation unit 7, the air exhaust mechanism 720 can generate an air flow in the Z direction. Note that a hooded fan is used for the air exhaust mechanism 720 in the embodiment, but only a fan or a hood may be simply used as another embodiment.

According to this arrangement, two evaluation units 7 adjacent to each other in the X or Z direction can be properly fixed to each other in various forms by the connecting portion 719. In two evaluation units 7 adjacent to each other in the Z direction, the supply chambers/exhaust chambers 702 can communicate with each other in the Z direction. According to this arrangement, the evaluation apparatus 1 can be relatively easily assembled by arraying the plurality of evaluation units 7. Accessorily, the connecting portion 719 may be further provided for the control chamber 703.

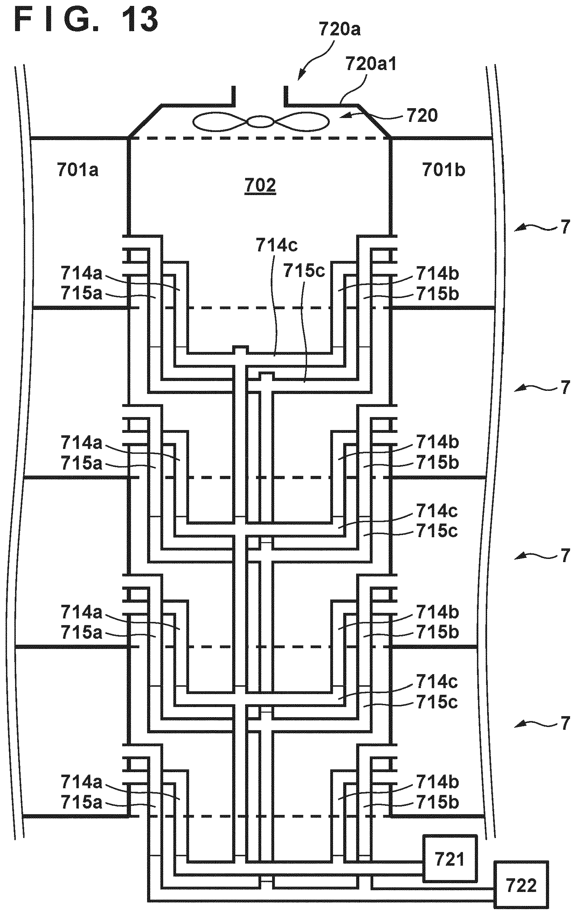

Fig. 13 is a schematic view showing a case in which the evaluation units 7 shown in Fig. 12 are arrayed in the Z direction. In this case, it is desirable that the plurality of supply chambers/exhaust chambers 702 communicating with each other in the Z direction further accommodate gas flow paths 714c and liquid flow paths 715c. Each gas flow path 714c is commonly connected to the gas flow paths 714a and 714b. Each liquid flow path 715c is commonly connected to the liquid flow paths 715a and 715b.

According to this structure, gas supply sources and liquid supply sources can be unified respectively. In the embodiment, as shown in Fig. 13, the evaluation apparatus 1 further includes a gas delivery portion 721 as a supply source for supplying a gas to the gas supply portion 711a and/or 711b via the gas flow paths 714a to 714c. Similarly, the evaluation apparatus 1 further includes a liquid delivery portion 722 as a supply source for supplying a liquid to the liquid supply portion 712a and/or 712b via the liquid flow paths 715a to 715c.

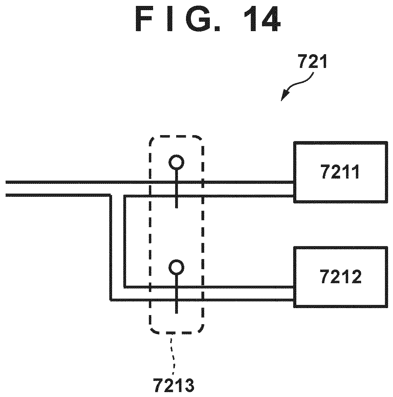

As shown in Fig. 14, the gas delivery portion 721 includes gas reservoirs 7211 and 7212 and a switching mechanism 7213. For example, the gas reservoir 7211 stores cool air (for example, cooled air) as the first gas, and the gas reservoir 7212 stores a non-flammable gas (for example, a digestive gas) as the second air. The switching mechanism 7213 is configured to deliver either of the two types of gases and switch the type of gas to be delivered. The switching mechanism 7213 can be, for example, an electromagnetic valve.

Note that the gas reservoirs 7211 and 7212 may be constituted as coupling portions that can be coupled to supply sources for supplying corresponding gases. In this case, the corresponding gases may be supplied by coupling the gas reservoirs 7211 and 7212 to gas reservoirs that can be installed in advance in a building such as a factory where the evaluation apparatus 1 is installed.

According to this arrangement, for example, in the first state in which the temperature environment state in the evaluation chamber 701a and/or 701b is lower than a reference value (for example, when the temperature in the evaluation chambers 701a and 701b is lower than a reference temperature owing to the evaluation operation of the evaluation target 5), cool air is delivered from the gas delivery portion 721 to and around a portion (in the embodiment, a portion where the evaluation execution portion contacts the evaluation target 5) where heat is generated owing to the evaluation operation of the evaluation target 5 by the evaluation execution portion, in order to suppress the temperature rise. The cool air is supplied to and around the evaluation target 5 placed in the reservoir 60 of the holder 6 placed in the evaluation chamber 701a and/or 701b.

In the second state in which the temperature environment state in the evaluation chamber 701a and/or 701b becomes higher than the reference value (for example, when the temperature in the evaluation chamber 701a and/or 701b becomes higher than the reference temperature owing to the evaluation operation of the evaluation target 5), a non-flammable gas is delivered from the gas delivery portion 721 and supplied into the evaluation chamber 701a and/or 701b. At this time, the switching mechanism 7213 operates to start or stop the supply from the first gas reservoir 7211, and start or stop the supply from the second gas reservoir 7212. The temperature environment state in the evaluation chamber 701a and/or 701b can be managed.

When the temperature environment state in the evaluation chamber 701a and/or 701b is the first state (for example, when the temperature in the evaluation chambers 701a and 701b is lower than the reference temperature owing to the evaluation operation of the evaluation target 5), this state is an idle state in which no liquid is delivered from the liquid delivery portion 722. When the temperature environment state in the evaluation chamber 701a and/or 701b is the second state in which the temperature environment state becomes higher than the reference value (for example, when the temperature in the evaluation chamber 701a and/or 701b becomes higher than the reference temperature owing to the evaluation operation of the evaluation target 5), a liquid is delivered from the liquid delivery portion 722. The delivered liquid is supplied to and stored in the reservoir 60 of the holder 6 via the liquid flow paths 715a to 715c and the liquid supply portion 712a and/or 712b. As another embodiment, the liquid delivery portion 722 may be configured to switch the type of liquid to be delivered, similar to the switching mechanism 7213 of the gas delivery portion 721.

In the evaluation apparatus 1, the temperature rise of the evaluation targets (the plurality of battery cells) 5 and evaluation execution portion is suppressed by cool air during characteristic evaluation by operation control of the gas delivery portion 721 and liquid delivery portion 722. When the temperature environment state in the evaluation chamber 701a and/or 701b becomes higher than the reference temperature due to heat generated during evaluation of the evaluation targets 5, cooling of the evaluation targets 5 and an abrupt change of the temperature environment state in the evaluation chamber 701a and/or 701b can be suppressed at once by supplying a non-flammable gas and a liquid. Driving control of the gas delivery portion 721 and liquid delivery portion 722 can be implemented by detecting environments in the evaluation chambers 701a and 701b. By using the communication portions 710a and 710b in addition to the gas delivery portion 721 and the liquid delivery portion 722, the temperature environment state in the evaluation chamber 701a and/or 701b can be efficiently managed.

In the embodiment, as illustrated in Figs. 8 and 9, the evaluation unit 7 further includes, in the respective evaluation chambers 701a and 701b, detectors 723 capable of detecting its environment. The detectors 723 are provided at the upper ends of the evaluation chambers 701a and 701b serving as the peripheries of the communication portions 710a and 710b of the evaluation chambers 701a and 701b. The detector 723 can be a known temperature sensor. A signal representing the detection result of the detector 723 is transmitted to, for example, the controller 716, and a program in the controller 716 is processed to transmit an operation control signal to the gas delivery portion 721 and the liquid delivery portion 722. As another embodiment, the gas delivery portion 721 and the liquid delivery portion 722 may be electrically controllably connected by an evaluation apparatus controller that manages and controls the overall evaluation apparatus 1. In this case, it is enough to transmit a signal representing the detection result of the detector 723 to the evaluation apparatus controller.

The detectors 723 are preferably installed above the evaluation targets 5. In the embodiment, the detectors 723 are installed at the upper ends of the evaluation chambers 701a and 701b serving as the peripheries of the communication portions 710a and 710b of the evaluation chambers 701a and 701b. However, it suffices for the detectors 723 to measure environments in the evaluation chambers 701a and 701b, mainly the temperatures of the evaluation targets 5, and the installation positions of the detectors 723 are not limited to those in the embodiment. For example, the detector 723 may be installed in the evaluation execution portion 709a (or 709b), or a plurality of detectors 723 may be installed.

### (Summary)

According to the above-described embodiment, the evaluation apparatus 1 capable of executing characteristic evaluation for the plurality of battery cells 5 can be relatively easily constituted, and the safety of the characteristic evaluation can be improved. Main features of the embodiment are as follows:

An aspect of the embodiment is directed to the evaluation holder 6 that holds the plurality of battery cells 5 in characteristic evaluation of the plurality of battery cells 5 and can transfer the plurality of battery cells 5 at once. The holder 6 includes the bottom wall 61, the peripheral wall 62, and the press mechanism 63. The bottom wall 61 is configured to align the plurality of battery cells 5 from one side to the other side and place them. The peripheral wall 62 is set to be higher than the plurality of battery cells 5 around the periphery of the bottom wall 61. The press mechanism 63 is configured to press the plurality of battery cells 5 from one side to the other side. The bottom wall 61 and the peripheral wall 62 form the reservoir 60 capable of storing a liquid. When the temperature of the plurality of battery cells 5 become higher than a reference temperature, the holder 6 can cool the plurality of battery cells 5 at once. Therefore, an apparatus capable of executing the characteristic evaluation can be relatively easily constituted, and the safety of the characteristic evaluation can be improved. Note that the liquid suffices to be a non-flammable liquid, and an optimal liquid is selected from, for example, water, seawater, and a fire-extinguishing foam and used in accordance with the evaluation targets 5.

Another aspect of the embodiment is directed to the evaluation units 7 capable of executing characteristic evaluation for the plurality of battery cells 5 held by the evaluation holder 6 so that they can be transferred at once. Each evaluation unit 7 includes the evaluation chamber 701a, the holder support portions 708a, the liquid supply portion 712a, and the liquid supply chamber 702a. The evaluation chamber 701a is configured to accommodate the holder 6 in characteristic evaluation. The holder support portions 708a are provided in the evaluation chamber 701a, and configured to support the holder 6 at a predetermined position. The liquid supply portion 712a is provided in the evaluation chamber 701a, and configured to supply a liquid into the holder 6 supported by the holder support portions 708a. The liquid supply chamber 702a is provided adjacent to the evaluation chamber 701a, and configured to accommodate the liquid flow path 715a connected to the liquid supply portion 712a. When the temperature environment state in the plurality of battery cells 5 or the evaluation chamber 701a becomes higher than the reference temperature, the evaluation unit 7 can cool the plurality of battery cells 5 and/or the inside of the evaluation chamber 701a at once. An apparatus capable of executing the characteristic evaluation can be relatively easily constituted, and the safety during evaluation can be improved.

Still another aspect of the embodiment is directed to the evaluation units 7 that can execute characteristic evaluation on the evaluation targets 5 and can be arrayed in a plurality in the Z direction (first direction). Each evaluation unit 7 includes the evaluation chamber 701a, the exhaust chamber 702, and the communication portion 710a. The evaluation chamber 701a is configured to accommodate the evaluation targets 5 in characteristic evaluation. The exhaust chamber 702 is adjacent to the evaluation chamber 701a in the X direction (second direction). The communication portion 710a makes the evaluation chamber 701a and the exhaust chamber 702 communicate with each other. When the plurality of evaluation units 7 are arrayed in the Z direction, the exhaust chamber 702 can communicate with another exhaust chamber 702 adjacent in the Z direction. According to this arrangement, when arraying the evaluation units 7 and assembling the evaluation apparatus 1, the exhaust chambers 702 are properly connected between the adjacent evaluation units 7, and a system arrangement capable of exhausting a gas in the evaluation chamber 701a can be relatively easily implemented. Hence, an apparatus capable of executing the characteristic evaluation can be relatively easily constituted, and the safety of the characteristic evaluation can be improved. Note that in the embodiment, the evaluation targets 5 are the plurality of battery cells 5, but can be various electronic devices or electronic components such as mobile terminals or semiconductor packages.

In the above description, the respective elements are specified by functionally relevant names to facilitate understanding. However, elements are not limited to those having the contents described in the embodiment as main functions, and may accessorily have them.

## Claims

1. An evaluation holder that holds a plurality of battery cells and can transfer the plurality of battery cells at once in characteristic evaluation of the plurality of battery cells, the evaluation holder **characterized by** comprising:
a bottom wall configured to align the plurality of battery cells aligned from one side to another side and place the plurality of battery cells;
a peripheral wall provided around a periphery of the bottom wall to be higher than the plurality of battery cells; and
a press mechanism that presses the plurality of battery cells from the one side to the other side,
wherein the bottom wall and the peripheral wall form a reservoir configured to store a liquid.

2. The evaluation holder according to claim 1, **characterized in that** the plurality of battery cells are held by the evaluation holder via an auxiliary holder for fixing relative positions of the plurality of battery cells, and
a positioning portion for positioning the auxiliary holder is provided on the bottom wall and/or the peripheral wall.

3. The evaluation holder according to claim 1 or 2, **characterized in that** the peripheral wall includes a first wall and a second wall as two portions arranged to face each other on the one side and the other side, and
the press mechanism includes:
a moving body that is provided on one of the first wall and the second wall, and moves to be able to press the plurality of battery cells in one direction; and
a guide member that slidably guides the moving body in the one direction.

4. The evaluation holder according to claim 3, **characterized in that** the moving body is provided to be able to store the liquid together with the bottom wall and the peripheral wall.

5. The evaluation holder according to any one of claims 1 to 4, **characterized in that** the peripheral wall includes a drainage portion configured to drain the liquid.

6. An evaluation unit configured to execute characteristic evaluation for a plurality of battery cells that are held by a holder and can be transferred at once, the evaluation unit **characterized by** comprising:
an evaluation chamber that accommodates the holder in characteristic evaluation;
a holder support portion that is provided in the evaluation chamber and supports the holder at a predetermined position;
a liquid supply portion that is provided in the evaluation chamber and can supply a liquid into the holder supported by the holder support portion; and
a liquid supply chamber that is provided adjacent to the evaluation chamber and accommodates a liquid flow path connected to the liquid supply portion.

7. The evaluation unit according to claim 6, **characterized by** further comprising a liquid receiving portion that is provided in the evaluation chamber and receives the liquid flowing from the holder.

8. The evaluation unit according to claim 6 or 7, **characterized in that** the evaluation chamber includes a partition and an opening/closing portion provided for the partition, and
the opening/closing portion includes a door member configured to load and unload the holder, and an opening/closing mechanism that implements an opening/closing operation of the door member.

9. The evaluation unit according to any one of claims 6 to 8, **characterized by** further comprising an evaluation execution portion that is provided in the evaluation chamber and executes the characteristic evaluation on the plurality of battery cells held by the holder.

10. The evaluation unit according to claim 9, **characterized in that** the evaluation chamber includes:
a first region in which the liquid supply portion is arranged;
a second region which is adjacent to the first region and in which the evaluation execution portion is arranged; and
a third region which is adjacent to the first region and the second region and in which the holder is arranged.

11. The evaluation unit according to any one of claims 6 to 10, **characterized in that** the evaluation unit includes a plurality of evaluation units that are arrayed and can be connected to each other, and further comprises a connecting portion configured to connect another adjacent evaluation unit, and
the connecting portion is configured to connect each of the evaluation chamber and the liquid supply chamber to one of the evaluation chamber and the liquid supply chamber of the other evaluation unit.

12. The evaluation unit according to any one of claims 6 to 10, **characterized by** further comprising:
a second evaluation chamber that is adjacent to the liquid supply chamber, is provided on a side of the liquid supply chamber opposite to the evaluation chamber, and accommodates the holder in the characteristic evaluation;
a second holder support portion that is provided in the second evaluation chamber and supports the holder at a predetermined position; and
a second liquid supply portion that is provided in the second evaluation chamber and can supply a liquid into the holder supported by the second holder support portion, and
the liquid supply portion further accommodates:
a second liquid flow path connected to the second liquid supply portion; and
a third liquid flow path commonly connected to the liquid flow path and the second liquid flow path.

13. The evaluation unit according to claim 12, **characterized in that** the evaluation unit includes a plurality of evaluation units that are arrayed,
the evaluation chamber serves as a first evaluation chamber,
the first evaluation chambers are arranged in a first column,
the second evaluation chambers are arranged in a second column, and
the liquid supply chambers are arrayed on a side of the second column with respect to the first evaluation chambers and a side of the first column with respect to the second evaluation chambers.

14. An evaluation system **characterized by** comprising:
an evaluation unit defined in any one of claims 6 to 13;
a preparation unit configured to make a preparation for the characteristic evaluation by holding the plurality of battery cells by the holder; and
a conveyance unit that reciprocates between the evaluation unit and the preparation unit to convey the holder holding the plurality of battery cells.

15. The evaluation system according to claim 14, **characterized in that** the plurality of battery cells are held by the holder via an auxiliary holder for fixing relative positions of the plurality of battery cells, and
the preparation unit includes a first transfer mechanism that transfers the holder, and a second transfer mechanism that transfers the auxiliary holder.
